# EUROPEAN PATENT SPECIFICATION

(11) **EP 0 412 154 B1**
(45) Date of publication and mention of the grant of the patent: **14.06.1995**
(21) Application number: 90904521.3
(22) Date of filing: 22.02.1990
(51) Int. Cl.: B23B 27/08, H01B 3/44, H01B 3/30

(54) **IMPROVED POLYIMIDE AND FLUOROPOLYMER CONTAINING FILMS AND LAMINATES**
POLYIMID UND FLUORPOLYMER ENTHALTENDE FILME UND SCHICHTSTOFFE
PELLICULES ET STRATIFIES CONTENANT DES POLYIMIDES ET DES FLUOROPOLYMERES

(30) Priority: 23.02.1989 US 314547
(43) Date of publication of application: 13.02.1991
(73) Proprietor: CHEMFAB CORPORATION, Merrimack New Hampshire 03054 (US)
(72) Inventor: EFFENBERGER, John, A., Bedford, NH 03102 (US); KOERBER, Keith, G., Goffstown, NH 03045 (US); LUPTON, E., C., Jr., Bedford, NH 03102 (US)
(74) Representative: Lucas, Brian Ronald
(86) International application number: US9000981
(87) International publication number: WO9009853

(56) References cited:
- EP-A- 0 159 942
- EP-A- 0 160 439
- FR-A- 1 557 565
- FR-A- 2 112 413
- US-A- 3 422 215
- US-A- 4 801 506

## Description

### BACKGROUND OF THE INVENTION

The present invention relates to novel polyimide and fluoropolymer containing films characterized by very high adhesion between the polyimide and fluoropolymer. Such films are useful, for example, in making electrical insulation tapes for avionic systems. Additionally, this invention relates to the combination of such films for use in the preparation of laminated composites of improved adhesion and cohesion as insulation for wire and cable constructions which have outstanding chemical, thermal, physical and mechanical properties, particularly improved resistance to arc tracking and cut-through.

High temperature wire and cable insulation, in particular insulation for aerospace wire and cable, requires a combination of excellent electrical properties, resistance to cut-through and abrasion, fire retardance, low smoke generation, safety in use, ease of stripping and termination, and resistance to chemicals and solvents. High temperature wire and cable insulation based on fluoropolymers, such as PTFE and copolymers of TFE with hexafluoropropylene, such as Teflon® FEP, or with perfluorovinyl ethers, such as Teflon® PFA, are well known in the art. While such insulation has excellent chemical resistance to fluids with which it may come into contact, such as "Skydrol®," and possesses outstanding dielectric and weathering properties as well, its mechanical properties are such that it frequently offers little resistance to scrape abrasion and exhibits less than desirable resistance to cut-through, particularly at the elevated temperatures associated with its use in avionic systems which specify operation at 180°C and can encounter excursions to 200°C.

In order to address this mechanical deficiency at elevated temperatures, insulating composites have been devised which incorporate polyimide resins as well as fluoropolymers. Such insulation is frequently based on polyimide films such as Kapton®, which are initially coated or laminated with TFE copolymers such as FEP or PFA, e.g., Kapton® F. These films are then slit into tapes which are self-adhering while they are wrapped on to conductors at elevated temperature. These wrapped tapes may then be taped over or extruded over with fluoropolymers to provide a wire insulation whose exterior exhibits the good chemical resistance, weatherability, and dielectric behavior of the fluoropolymer, and whose polyimide interior provides the mechanical toughness to offer good scrape abrasion and cut-through resistance at elevated temperatures.

While constructions containing polyimide are thought to have a very desirable balance of properties since the polyimide has very good high temperature properties, excellent fire retardance and very good electrals, it has been determined that under some conditions polyimide-containing constructions can arc track, resulting in the formation of a carbonaceous char. The resulting conductive path can rapidly propagate when seemingly small voltages are applied. Arc tracking is a catastrophic failure in the presence of an electrical arc when a short circuit occurs between the conductor and a conducting medium external to the insulation such as a moderately conductive fluid. Such a failure may be occasioned by relatively slight mechanical damage to the insulation which becomes rapidly enlarged at the elevated temperature of the electrical arc.

Fluoropolymers and fluoropolymer-containing materials have excellent electrical properties, including a very low tendency to arc track. However, fluoropolymers are generally soft and prone to cut-through and creep particularly at the elevated temperatures where the use of insulated constructions in avionics is desired.

Many such hybrid constructions of polyimides and fluoropolymers contain layers of TFE copolymers exclusively. However, the presence of a fluoropolymeric layer in the taping elements which is exclusively a TFE copolymer, such as FEP or PFA, results in a tape wrapping element which can be susceptible to delamination at elevated temperatures when only modest adhesion between the polyimide and fluoropolymer is achieved as in the current state of the art. A further short-coming of known polyimide insulation based on tapes employing bonding layers which contain exclusively TFE copolymers is that such insulation does not consistently exhibit good resistance to art tracking. An example of such a hybrid construction employing a bonding layer which contains exclusively TFE copolymers is disclosed in US-A-3 422 215.

The bond between the polyimide and FEP or PFA directly applied to the polyimide in present films such as Kapton^{R} F is not as fully developed as it could be, being typically about 700 N/m (4 lb/inch) at room temperature. Since these copolymers begin to soften and flow even below their melting point, the failure mechanism at the interface for these known films is adhesive and peeling can be initiated at relatively low temperatures compared to their melting temperatures.

Other polyimide/fluoropolymer based tapes such as DE2929 or DE2919 have been commercially available from Chemical Fabrics Corporation. While these tapes contain PTFE homopolymer and a topcoat of PTFE copolymer, such as FEP or PFA, over the polyimide, they do not exhibit the very high adhesion developed between the polyimide and fluoropolymer as do the invention films.

US-A-3 616 177 describes an asymmetric laminar structure comprising polyimide coated on one or both sides with an FEP copolymer and further coated on one side with a PTFE polymer. However, such a structure is prone to delamination at high temperatures due to the use of a TFE copolymer (FEP) directly on the polyimide layer with only modest adhesion.

US-A-4 628 003 discloses a heat sealable, high temperature insulative wrapping. The wrapping is a film comprised of a polyimide coated with two fluoropolymer layers. Various fluoropolymers, such as hexafluoropropylene/-tetrafluoroethylene copolymers and perfluoroalkyvinylether and perfluoropropylvinylether copolymers with tetrafluoroethylene, are useful in the fluoropolymer layers. Each fluoropolymer layer also contains a pigment to provide colouration and act as an infrared absorber, and also results in increased retention of heat seal bond strengths after heat aging. The polyimide film may also be treated with a silane to improve adhesion of the fluoropolymer layers. These laminate compositions, however, do not entirely avoid the serious problems occasioned by modest interfacial adhesion, particularly at the polyimide/fluoropolymer interface.

The technical problem with which this invention is concerned is to provide polyimide and fluoropolymer films suitable for making insulation tapes which are resistant to cut through at high temperatures and in which the tendency of known laminations of arc track is reduced.

This problem is solved according to the invention by the multi-layer composite of Claim 1 and by the method of Claim 15.

A multi-layer film of improved adhesive strength can be made by combining a polyimide-containing film and one or more adhesive layers comprising a blend of PTFE and at least one thermally compatible TFE copolymer. It has been found that the peel adhesion between the polyimide-containing film and any adhesive layer is greatly improved over known products and can be at least 1575 N/m (nine pounds per inch). Multi-layer composites of improved adhesion and cohesion made using such a multi-layer film and at least one fluoropolymer film are equally satisfactory. It should be understood that the fluoropolymer film or films should be thermally weldable to the polyimide-containing film, which fluoropolymer film may comprise fluoropolymer selected from the group consisting of PTFE, thermally compatible TFE copolymers, and any combination or blend thereof. The term "TFE copolymers" as used herein includes copolymers of TFE with other ethylenically unsaturated monomers, such as with HFP (hexafluoropropylene) and known as FEP (fluorinated ethylene propylene); or with perfluoropropyl vinyl ether and known as PFA. The adhesive layer or layers may also be a blend of PVF₂ and at least one thermally compatible VF₂ copolymer.

Insulation tape for wire and cable made using these multi-layer composites are particularly useful in aerospace applications since they do not suffer the drawbacks of similar prior art composites.

The present invention also relates to a method of preparing a multi-layer composite, which comprises preparing at least one polyimide-containing film; coating the polyimide-containing film with an adhesive layer of the type defined in claim 1; coating the adhesive layer on at least one surface of the polyimide-containing film with a fluoropolymer film; applying a second fluoropolymer film to the adhesive layer on at least one surface of the polyimide-containing layer; and thermally welding the layers to form a composite.

The claimed composites can be used as insulating tapes for wires. Such tapes provide the advantages of maximizing the PTFE content of the insulating system to provide the best electrical performance while optimizing the balance between thermal processability and cohesive structural integrity.

It has been found that blends of TFE copolymers with PTFE homopolymer can be made resistant to delamination from the polyimide at elevated temperatures, resulting in adhesion to the polyimide which is about three times stronger than that of the state of the art TFE copolymer clad polyimides at room temperature. Blends of TFE copolymers with PTFE used as cladding and cladding components exhibit a high temperature failure mechanism which is cohesive rather than adhesive even at temperatures above that of the melting point of the copolymer and approaching that of the homopolymer itself. This is unexpected, since the prior art emphasizes the desirability of employing only TFE copolymers such as FEP or PFA to achieve this bond. It has been found that a wire insulated with fluoropolymer and fluoropolymer clad polyimide tapes is significantly more resistant to arc tracking when the total fluoropolymer content is based more upon PTFE than is copolymers. In this regard, incorporation of PTFE into the adhesive layers containing copolymer provides the additional benefit of improving arc track resistance as well as adhesion since the adhesive layers in any given taping element may be kept relatively thin (! 0.2 mils) permitting maximal use of PTFE.

It is advantageous from a processing point of view to utilize a combination of PTFE and a thermally compatible TFE copolymer as the adhesive layer material, since the use of PTFE alone necessitates processing temperatures and times that may lead to degradation of the strength of the polyimide or polyimide/fluoropolymer interface. Thermally compatible TFE copolymers must be used according to the claimed invention, meaning these copolymers must be co-processable with PTFE so as to provide a fused blend of the polymers with good physical properties. Such processing methods are described in applicant's copending applications, US Application Serial Nos. 226 614 (now US-A-4 883 716) and 305 748 (now US-A-5 141 800), which are incorporated herein by reference.

Preferably, the thermally compatible TFE copolymer is selected from the group consisting of FEP and PFA. By utilizing a blend of PTFE and FEP or PFA as an adhesive layer between the composite films, subsequent co-wrapping of the tapes to create a wire insulation system is facilitated and results in a very high degree of cohesion at all interfaces. Moreover, since the copolymer is present in each of the mating faces of the tapes to be bonded, little mass transport is actually required in the melt to achieve the bond. Thus, it requires minimum time and temperature to affect the desired result.

The wire insulation constructions of the invention are richer in PTFE than those presently in use, since the bonding layers between the polyimide-containing and fluoropolymer films employed in the system contain both PTFE and TFE copolymers. Such a construction is more resistant to catastrophic failure in the presence of an electrical arc than systems which are richer in polyimide and which employ less well bonded copolymers alone in such bonding layers.

For these reasons, it is preferable to maximize the PTFE content in such composites. One or more of the fluoropolymer films may be formed from PTFE. If PTFE is used in a bonding layer such that it is in an unfused condition in a tape ready for wrapping on a wire, the thickness of such a layer should be about 0.005-0.01mm (0.2-0.4 mil). In addition, the thickness of the adhesives layers, if they contain TFE copolymer, should be minimized.

While the details of the fluoropolymer behaviour in the presence of an intense, high temperature electrical arc are not completely understood, improved arc tracking of the claimed composites may well involve the well-known ablative behaviour of PTFE at elevated temperatures. For that reason, it may also be beneficial to incorporate additives into the fluoropolymer layers used to create an insulation system which are also ablative in nature.

Such additives include minerals which outgas at the temperature of the arc, such as carbonates which evolve carbon dioxide, e.g., calcium or magnesium carbonate, or minerals containing water of hydration. Other suitable additives would include polymers which, like PTFE itself, decompose without producing carbonaceous or other conductive by-products on decomposition. These additives may be incorporated into the fluoropolymer layers of the claimed composite preferably in those layers nearest the conductor to be insulated.

In order to avoid bonding of any fluoropolymer film of the claimed composite to the conductor itself during tape wrapping, it is desirable that the face of the interior layer adjacent to the conductor contain PTFE alone while its opposite face contains an adhesive comprising a blend of PTFE and a thermally compatible TFE copolymer to promote thermal welding to itself and other layers in the construction.

At least one pigment may be incorporated into any of the fluoropolymer layers, films or adhesives of the claimed composite for purposes of laser marking. Such pigment may comprise 3-15% by weight of a fluoropolymer film or layer, preferably 4-10% by weight and most preferably 4-8% by weight. For example, an exterior fluoropolymer film of PTFE may be used which incorporates one pigment. Alternatively, two films may be used for this purpose, each incorporating different pigments of contrasting colours. Laser etching of the outermost pigmented film would then reveal the contrasting colour for identification of the wire type. The outermost pigmented film should not be thicker than about 0.006 cm (0.25 mil) in order to obtain sharp definition of the identifying code at the energy density of lasers presently commercially available.

Suitable material for use in the polyimide-containing film of the claimed composite is set forth in US-A-3 616 177, the disclosure of which is incorporated herin by reference. Kapton^{R} H, Kapton^{R} HN, or Kapton^{R} F may be used in the polyimide layer, as well as other polyimide films such as Apical^{R} or Upilex^{R}. The polyimide film layer should have a thickness of about 0.0127-0.05 mm (0.5-2.0 mil), preferably 0.0178-0.025 mm (0.7-1.0 mil).

PTFE for use in the claimed invention should have a high molecular weight with a melt viscosity of at least 10¹⁰ poise, preferably 10¹⁰-10¹² poise, at 380°C. PTFE for use in the claimed invention may be derived from aqueous dispersion of such materials as Teflon^{R} 30, AD^{R} 1, and Algoflon^{R} 60.

Such PTFE is combined with a thermally compatible TFE copolymer, preferably FEP and PFA, to form the adhesive layers of the composite. If FEP is used, it should have a melting point of 268°C and a melt viscosity of 3x10⁴-2.5x10⁵ poise at 372°C. FEP may be derived from aqueous dispersion of such materials at Teflon^{R} 120, Teflon^{R} TE 9503, and Teflon^{R} TE 5582.

If PFA is used in the adhesive layers of the claimed invention, it should have a melting point of 305°C and a melt viscosity of 3x10⁴-2.5x10⁵ point at 372°C. PFA may be derived from aqueous dispersion of a material such as Teflon^{R} 322 J. The adhesive layers may be applied by either coating or lamination techniques. Preferably they are formed by aqueous dispersion coating.

The adhesive layers should contain at least 40% by volume PTFE, with the remainder being TFE copolymer with which it is thermally compatible. When the adhesive is PTFE with TFE copolymer, the amount of PTFE may be 60-40% by volume of the adhesive. The most preferred composition for the adhesive layers is 50% by volume PTFE and 50% by volume thermally compatible TFE copolymer. The thickness of each adhesive layer may be 0.00127-0.05 mm (0.05 to 2 mil), preferably 0.002-0.004 mm (0.08 to 0.15 mil) except where an adhesive layer is adjacent to PTFE when it is preferred to be 0.0038-0.01 mm (0.15-0.40 mil) thick. Each fluoropolymer layer may be 0.0127-0.038 mm (0.50-1.50 mil) thick, preferably 0.019-0.03 mm (0.75-1.20 mil) thick and the overall thickness of the composite may be 0.02-0.05 mm (0.80-2.0 mil).

The claimed composite material may be used to prepare a large variety of insulative wraps. The thickness of individual layers, overall weight of the insulation, and the degree of overlap among layers may all be varied to provide a desired insulation product with any given wall thickness. For example, two central polyimide films may be layered on one surface with double PTFE films, with adhesive layers as described above sandwiched in between. Further PTFE films may be applied to another surface of the polyimide film, also with adhesive layers sandwiched in between. This forms a central polyimide-containing film, an exterior PTFE-containing film and an interior PTFE-containing film. Pigmentation may be incorporated in the outermost PTFE film while ablatives may be incorporated in the PTFE films nearest the conduction. The adhesive layers of the claimed invention provide superior bonding of the entire wrap.

The following non-limiting examples are designed to further illustrate the claimed invention.

### Example 1

A 0.005 cm (2 mil) polyimide film of Kapton^{R} HN was initially coated with an aqueous dispersion blend of PTFE and PFA derived from Teflon^{R} 30B and teflon^{R} 322J respectively, such that a 0.0013 cm (0.05 mil resin coating was obtained containing 50% by weight PTFE and 50% by weight PFA on each face of the polyimide film. This film was subsequently coated with Teflon^{R} 30B dispersion to build an overcoat to the alloyed copolymer layer of 0.0125 mm (0.5 mils) of PTFE. Lastly, a topcoat of the same PTFE/PFA alloy was applied using the same codispersion employed in the initial coat. These coatings were applied in a conventional dip coating tower with an evaporation/baking zone of 2.13 m (seven feet) in length and a fusing zone of 2.13 m (seven feet) in length at a line speed of 90-120 cm (3-4 feet) per minute. The web temperature in the fusing zone was about 360°C (680°F).

This multi-layer, fluoropolymer-clad polymide film exhibited a room temperature, 180° peel adhesion strength of about 700 N/m (4 lb/inch), comparable to that specified for other fluoropolymer clad polyimides such as Kapton^{R} F.

This film was subsequently given additional thermal treatment by running it through a convectively heated oven with a 2.4 m (eight foot) long drying zone and an 2.4 m (eight foot) long baking/fusing zone. An additional source of thermal energy contained within the basing/fusing zone of the convective oven was a 1.2 m (four foot) long electrical radiant heater with a maximum watt density of 3.4 watts/cm² (22 watts per square inch).

The linear rate of travel of the film through the oven was 1.52 m (five feet) per minute and the temperature of the convectively heated fusing zone was 400°C (750°F). Importantly, the radiant heater was energized to provide a 538°C (1000°F) emitter temperature. Residence time for the film exposed to this radiant emitter was about 45 seconds.

After this thermal treatment, the peel adhesion at room temperature rose dramatically to over 1575 N/m (9 lb/inch), well above that of any commercially available fluoropolymer clad polyimide film which by the same method of measurement is typically 528-875 N/m (3-5 lb/inch).

Of equal importance, it was found that when this type of film was sealed to itself at 354°C (670°F) under moderate pressure, examination of the tendency of the bond to creep under constant load in a 180° peel mode and at elevated temperature (350°C) was dramatically reduced relative to that of fluoropolymer clad films based upon TFE copolymer alone. At 350°C (above the melting point of both the PFTE and PFA) and under an 87 N/m (0.5 lb/inch) load, the peel rate was 1.5-3 mm (1/16-1/8 inches) per minute. This low rate of high temperature creep of this fluoropolymer cladding is believed to translate to superior high temperature cut-through resistance and is indicative of the virtue of incorporating PTFE into the adhesive layer.

Additionally, microscopic examination of the peeled surface showed that adhesive failure of the fluoropolymer to polyimide had not occurred. Rather cohesive failure within the alloyed adhesive or PTFE layer itself had occurred demonstrating a great thermal stability of the adhesive bond between the polyimide and fluoropolymer in the invention film. The observed failure mechanism for fluoropolymer clad polyimides based upon TFE copolymers alone such as FEP and which do not exhibit high room temperature adhesion is adhesive and can be initiated well below the fluoropolymer melting point.

Films of this invention type by virtue of their well developed adhesion, in combination with fluoropolymer films with similar adhesive layers, have been found to be outstanding as tape-wrapped wire insulation. Higher cut-through resistance and excellent arc track behaviour have been observed.

### Example 2

A 0.025 mm (1.0 mil) film of Kapton^{R} HN was coated with the same alloyed PTFE/PFA dispersion as described in Example 1 to provide a thin fluoropolymeric adhesive layer.

Absent the radiant heat history (538°C (1000°F) emitter) described in Example 1, the peel strength of this fluoropolymer clad polyimide film to a 0.075 mm (3 mil) cast PTFE film containing a 0.025 mm (0.1 mil) layer of PFA on each surface was only 175 N/M (1.0 lb/inch).

After the same thermal radiant treatment of the coated polyimide, as described in Example 1, the peel strength rose to 2187 N/m (12.5 lb/inch) indicating the ability of such a well-bonded, alloyed PTFE/PFA adhesive to form a very strong, cohesive bond to a fluoropolymer film with a TFE copolymer surface.

It has also been observed that somewhat high emitter temperatures (1040°F) are more effective for creating strong adhesive bonds of PTFE alloys to TFE copolymers or PTFE/TFE copolymer alloys.

Additionally, slightly higher emitter temperatures (less than 1080°F) are effective in promoting strong adhesion of PTFE itself to a polyimide. While operable, these emitter temperatures are high enough to begin to degrade the polyimide itself but may be accommodated by varying line speed.

## Claims

1. A multi-layer composite of improved adhesion comprising at least one polyimide-containing film, at least one fluoropolymer film applied to the polyimide containing film, and an adhesive layer applied between the or each polyimide-containing film and the or each fluoropolymer-containing film, characterized in that
(1) the or each adhesive layer comprises
(a) a blend of PTFE and at least one thermally compatible TFE copolymer, or
(b) a blend of PVF₂ and at least one thermally compatible VF₂ copolymer, and
(2) the films are thermally weldable or thermally welded.

2. The composite of Claim 1, wherein the or each adhesive layer comprises a blend of PTFE and at least one thermally compatible TFE copolymer.

3. The composite of Claim 2, in which the films are thermally welded, and upon peel adhesion evaluation of the composite at high temperature delamination occurs by cohesive failure within the adhesive layer rather than by adhesive failure between the polyimide film and the adhesive layer.

4. The composite of Claim 1, 2 or 3, wherein the polyimide film layer is of thickness 0.0127-0.05mm (0.5-2 mil).

5. The composite of Claim 1, 2 or 3, wherein the polyimide film layer is of thickness 0.0178-0.025mm (0.7-1.0 mil).

6. The composite of Claim 2 and any of Claims 3-5 when dependent thereon, wherein the thickness of the or each adhesive layer is 0.00127-0.005mm (0.05 to 0.2 mil).

7. The composite of Claim 2 and any of Claims 3-5 when dependent thereon, wherein the thickness of each adhesive layer is 0.002-0.004mm (0.08 to 0.15 mil).

8. The composite of Claim 2 and any of Claims 3-5 when dependent thereon, wherein when the or each adhesive layer is adjacent to PTFE, the adhesive layer is 0.0038-0.01mm (0.15-0.4 mil) thick.

9. The composite of Claim 2 and any of Claims 3-8 when dependent thereon, wherein each fluoropolymer layer is 0.0127-0.038mm (0.5-1.50 mil) thick.

10. The composite of Claim 2 and any of Claims 3-8 when dependent thereon, wherein each fluoropolymer layer is 0.019-0.03mm (0.75-1.20 mil) thick.

11. The composite of Claim 2 and any of Claims 3-10 when dependent thereon, wherein the fluorocarbon film comprises an ablative additive selected from the group consisting of carbonates that evolve carbon dioxide, minerals containing water of hydration, and polymers that decompose without producing carbonaceous or conductive by-products on decomposition.

12. The composite of Claim 2 and any of Claims 3-11 when dependent thereon, wherein the fluorocarbon film further comprises at least one layer of pigment.

13. The composite of any preceding Claim, wherein the adhesive is PTFE blended with FEP or PFA.

14. The composite of Claim 2 and any of Claims 3-11 when dependent thereon, wherein the or each fluoropolymer film is 100% PTFE.

15. A method of preparing a multi-layer composite as claimed in any preceding Claim, which comprises
(1) coating a polyimide-containing film with an adhesive layer which comprises
(a) a blend of PTFE and at least one thermally compatible TFE copolymer, or
(b) a blend of PVF₂ and a thermally compatible VF₂ copolymer; and
(2) applying a fluoropolymer film to the polyimide containing film.

16. The method of Claim 15, wherein the materials applied to form the adhesive layer are selected from:
PTFE of melt viscosity 10¹⁰-10¹² poise at 380°C;
FEP, melting point 268°C and melt viscosity 3 x 10⁴ to 2.5 x 10⁵ poise at 372°C;
PFA of melting point 305°C and melt viscosity 3 x 10⁴ to 2.5 x 10⁵ poise at 372°C.

17. The method of Claim 15 or 16, wherein the material applied to form the adhesive layer comprises 50% by volume PTFE and 50% by volume thermally compatible TFE copolymer.

18. The method of Claim 15, 16 or 17, comprising the further step of thermally treating the film to weld the layers together.

19. A wire insulated with tape comprising a multi-layer composite of any of Claims 1-14 or made by the method of any of Claims 15-17.

## Patentansprüche

1. Mehrlagiger Verbund mit verbesserter Adhäsion, bestehend aus wenigstens einem Polyimid enthaltenden Film, wenigstens einem auf den Polyimid enthaltenden Film aufgetragenen Fluorpolymerfilm und aus einer adhäsiven Lage zwischen dem oder jedem Polyimid enthaltenden Film und dem oder jedem Fluorpolymer enthaltenden Film,
dadurch gekennzeichnet, daß
(1) die oder jede adhäsive Lage aus
(a) einer Mischung aus Polytetrafluorethylen (PTFE) und wenigstens einem thermisch kompatiblen Tetrafluorethylenkopolymer (TFE-Kopolymer) oder
(b) einer Mischung aus Polyvinyldifluorid (PVF₂) und wenigstens einem thermisch kompatiblen Vinyldifluoridkopolymer (VF₂-Kopolymer) besteht, und daß
(2) die Filme thermisch schweißbar oder thermisch verschweißt sind.

2. Verbund nach Anspruch 1, in welchem die oder jede adhäsive Lage eine Mischung aus PTFE und wenigstens einem thermisch kompatiblen TFE-Kopolymer enthält.

3. Verbund nach Anspruch 2, in welchem die Filme thermisch verschweißt sind, und daß sich nach der Adhäsionsschälauswertung des Verbundes bei hoher Temperatur eine Delamination eher durch kohäsive Fehler in der adhäsiven Lage ergibt als durch adhäsive Fehler zwischen dem Polyimidfilm und der adhäsiven Lage.

4. Verbund nach Anspruch 1, 2 oder 3, in welchem die Polyimidfilmlage eine Dicke von 0,0127-0,05 mm (0,5-2 Milli-inch) hat.

5. Verbund nach Anspruch 1, 2 oder 3, in welchem die Polyimidfilmlage eine Dicke von 0,0178-0,025 mm (0,7-1,0 Milli-inch) hat.

6. Verbund nach Anspruch 2 und einem der Ansprüche 3 bis 5, wenn davon abhängig, in welchem die Dicke der oder jeder adhäsiven Lage 0,00127-0,005 mm (0,05 bis 0,2 Milli-inch) beträgt.

7. Verbund nach Anspruch 2 und einem der Ansprüche 3 bis 5, wenn davon abhängig, in welchem die Dicke jeder adhäsiven Lage 0,002-0,004 mm (0,08-0,15 Milli-inch) beträgt.

8. Verbund nach Anspruch 2 und einem der Ansprüche 3 bis 5, wenn davon abhängig, in welchem, wenn die oder jede adhäsive Lage sich neben dem PTFE befindet, die adhäsive Lage 0,0038-0,01 mm (0,15-0,4 Milli-inch) dick ist.

9. Verbund nach Anspruch 2 und einem der Ansprüche 3 bis 8, wenn davon abhängig, in welchem jede Fluorpolymerlage 0,0127-0,0038 mm (0,5-1,50 Milli-inch) dick ist.

10. Verbund nach Anspruch 2 und einem der Ansprüche 3 bis 8, wenn davon abhängig, in welchem jede Fluorpolymerlage 0,019-0,03 mm (0,75-1,20 Milli-inch) dick ist.

11. Verbund nach Anspruch 2 und einem der Ansprüche 3 bis 10, wenn davon abhängig, in welchem der Fluorkohlenstoff-Film wärmeabsorbierende Additive auserwählt aus der Gruppe, bestehend aus Karbonaten, die CO₂ ausscheiden, Mineralien, Wasser durch Hydratisierung enthaltend und Polymeren, die sich auflösen, ohne kohlenstoffhaltige oder leitfähige Nebenprodukte bei der Auflösung zu produzieren.

12. Verbund nach Anspruch 2 und einem der Ansprüche 3 bis 11, wenn davon abhängig, in welchem der Fluorkohlenstoff-Film ausserdem wengistens eine Pigmentschicht enthält.

13. Verbund nach einem der vorhergehenden Ansprüche, in welchem der Kleber PTFE ist, gemischt mit FEP oder PFA.

14. Verbund nach Anspruch 2 und einem der Ansprüche 3 bis 11, wenn davon abhängig, in welchem der oder jeder Fluorpolymerfilm zu 100 % PTFE ist.

15. Verfahren zur Herstellung eines mehrlagigen Verbundes nach einem der vorhergehenden Ansprüche mit folgenden Verfahrensschritten:
(1) Überziehen eines Polyimid enthaltenden Films mit einer Kleberschicht aus
(a) einer Mischung aus PTFE und wenigstens einem thermisch kompatiblen TFE-Kopolymer oder
(b) einer Mischung aus PVF₂ und einem thermisch kompatiblen VF₂-Kopolymer, und
(2) Aufbringen eines Fluorpolymer-Films auf den Polyimid enthaltenden Film.

16. Verfahren nach Anspruch 15, für welches die Stoffe zur Bildung der Kleberschicht ausgewählt sind aus:
PTFE mit einer Schmelzviskosität 10¹⁰-10¹² Poise bei 380°C;
FEP mit einem Schmelzpunkt von 268°C und einer Schmelzviskosität von 3x10⁴ bis 2,5x10⁵ Poise bei 372°C;
PFA mit einem Schmelzpunkt von 305°C und einer Schmelzviskosität von 3x10⁴ bis 2,5x10⁵Poise bei 372°C.

17. Verfahren nach Anspruch 15 oder 16, für welches der Stoff zur Bildung der Kleberschicht aus 50 vol% PTFE und 50 vol% thermisch kompatiblem TFE-Kopolymer besteht.

18. Verfahren nach Anspruch 15, 16 oder 17 mit dem weiteren Schritt einer thermischen Behandlung des Films zum Zusammenschweißen der Lagen.

19. Draht, isoliert mit einem Band aus einem mehrlagigen Verbund nach einem der Ansprüche 1 bis 14 oder hergestellt nach dem Verfahren nach einem der Ansprüche 15 bis 17.

## Revendications

1. Composite multicouches doté d'une meilleure adhérence comprenant au moins un film à base de polyimide, au moins un film à base de polymère fluoré appliqué sur le film à base de polyimide, et une couche adhésive appliquée entre le ou chacun des films à base de polyimide et le ou chacun des films à base de polymère fluoré, caractérisé en ce que
(1) la ou chacune des couches adhésives comprend:
(a) un mélange de PTFE et d'au moins un copolymère de TFE thermocompatible, ou
(b) un mélange de PVF₂ et d'au moins un copolymère de VF₂ thermocompatible, et en ce que
(2) les films sont thermosoudables ou thermosoudés.

2. Composite selon la revendication 1, dans lequel la ou chacune des couches adhésives comprend un mélange de PTFE et d'au moins un copolymère de TFE thermocompatible.

3. Composite selon la revendication 2, dans lequel les films sont soudés par la chaleur, caractérisé en ce qu'à l'examen de la résistance au pelage du composite à haute température, il se produit un décollement des couches par rupture de cohésion au sein de la couche adhésive plutôt que par rupture d'adhérence entre le film de polyimide et la couche adhésive.

4. Composite selon la revendication 1, 2 ou 3, dans lequel la couche formée d'un film de polyimide a une épaisseur de 0,0127-0,05 mm (0,5-2 mil).

5. Composite selon la revendication 1, 2 ou 3, dans lequel la couche formée d'un film de polyimide a une épaisseur de 0,0178-0,025 mm (0,7-1,0 mil).

6. Composite selon la revendication 2 et l'une quelconque des revendications 3 à 5 lorsqu'elles dépendent de celle-ci, dans lequel l'épaisseur de la ou de chacune des couches adhésives est de 0,00127-0,005 mm (0,05 à 0,2 mil).

7. Composite selon la revendication 2 et l'une quelconque des revendications 3 à 5 lorsqu'elles dépendent de celle-ci, dans lequel l'épaisseur de la ou de chacune des couches adhésives est de 0,002-0,004 mm (0,08 à 0,15 mil).

8. Composite selon la revendication 2 et l'une quelconque des revendications 3 à 5 , lorsqu'elles dépendent de celle-ci, dans lequel la couche adhésive la couche adhésive est de 0,0038-0,01 mm (0,15-0,4 mil) d'épaisseur lorsque la ou chacune des couches adhésives est adjacente au PTFE.

9. Composite selon la revendication 2 et l'une quelconque des revendications 3 à 8 lorsqu'elles dépendent de celle-ci, dans lequel chacune des couches de polymère fluoré est de 0,0127-0,038 mm (0,5-1,50 mil) d'épaisseur.

10. Composite selon la revendication 2 et l'une quelconque des revendications 3 à 8 , lorsqu'elles dépendent de celle-ci, dans lequel chacune des couches de polymère fluoré est de 0,019-0,03 mm (0,75-1,20 mil) d'épaisseur.

11. Composite selon la revendication 2 ou l'une quelconque des revendications 3 à 10 lorsqu'elles dépendent de celle-ci, dans lequel le film de carbone fluoré comprend un additif ablatif choisi dans le groupe constitué de carbonates émetteurs de dioxyde de carbone, de minéraux contenant de l'eau d'hydratation, et de polymères dont la décomposition ne s'accompagne pas de formation de sous-produits carbonés ou conducteurs.

12. Composite selon la revendication 2 et l'une quelconque des revendications 3 à 11 lorsqu'elles dépendent de celle-ci, dans lequel le film de carbone fluoré comprend en outre au moins une couche de pigment.

13. Composite selon l'une quelconque des revendications précédentes, dans lequel l'adhésif est un mélange de PTFE et de FEP ou de PFA.

14. Composite selon la revendication 2 et l'une quelconque des revendications 3 à 11 , lorsqu'elles dépendent de celle-ci, dans lequel le ou chacun des films de polymère fluoré est 100% PTFE.

15. Procédé de préparation d'un composite multicouches tel que revendiqué dans l'une quelconque des revendications précédentes, qui comprend les étapes consistant à
(1) recouvrir un film à base de polyimide avec une couche adhésive comprenant:
(a) un mélange de PTFE et d'au moins un copolymère de TFE thermocompatible, ou
(b) un mélange de PVF₂ et d'un copolymère de VF₂ thermocompatible; et
(2) à appliquer un film de polymère fluoré au film à base de polyimide.

16. Procédé selon la revendication 15, dans lequel les matériaux servant à réaliser la couche adhésive sont choisis parmi:
du PTFE, de viscosité à l'état fondu de 10¹⁰-10¹² poises à 380°C;
du FEP, de point de fusion de 268°C et une viscosité à l'état fondu de 3 x 10⁴ à 2,5 x 10⁵ poises à 372°C;
du PFA, de point de fusion de 305°C et une viscosité à l'état fondu de 3 x 10⁴ à 2,5 x 10⁵ poises à 372°C.

17. Procédé selon la revendication 15 ou 16, dans lequel le matériau servant à réaliser la couche adhésive comprend 50% en volume de PTFE et 50% en volume d'un copolymère de TFE thermocompatible.

18. Procédé selon la revendication 15, 16 ou 17, comprenant une étape supplémentaire qui consiste à traiter le film à la chaleur afin de souder les couches les unes aux autres.

19. Fil protégé par un ruban isolant comprenant un composite multicouches selon l'une quelconque des revendications 1 à 14 ou fabriqué selon le procédé conforme à l'une des revendications 15 à 17.
